(19) Europäisches Patentamt
European Patent Office
Office européen des brevets

(11) EP 2 178 347 A1

(12) **EUROPEAN PATENT APPLICATION**
published in accordance with Art. 153(4) EPC

(43) Date of publication:
**21.04.2010 Bulletin 2010/16**

(21) Application number: **08778193.6**

(22) Date of filing: **09.07.2008**

(51) Int Cl.:
***H05B 33/10*** *(2006.01)* ***H01L 51/50*** *(2006.01)*

(86) International application number:
**PCT/JP2008/062776**

(87) International publication number:
**WO 2009/008543 (15.01.2009 Gazette 2009/03)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **12.07.2007 JP 2007182982**

(71) Applicant: **Sumitomo Chemical Company, Limited**
**Tokyo 104-8260 (JP)**

(72) Inventors:
- **YAMAUCHI, Shohgo**
**Tsukuba-shi**
**Ibaraki 305-0005 (JP)**
- **IWASAKI, Masataka**
**Tsukuba-shi**
**Ibaraki 305-0821 (JP)**

(74) Representative: **Duckworth, Timothy John**
**J.A. Kemp & Co.**
**14 South Square**
**Gray's Inn**
**London WC1R 5JJ (GB)**

# (54) METHOD FOR MANUFACTURING ORGANIC LIGHT-EMITTING DEVICE

(57) A method for producing an organic light emitting device having an anode, a layer containing an electron accepting organic compound, a hole transporting layer containing an organic compound, a light emitting layer containing a macromolecular compound, and a cathode in this order,the layer containing the electron accepting organic compound being in contact with the anode and the hole transporting layer,
wherein the layer containing the electron accepting organic compound is formed by producing a film by using a composition comprising the electron accepting organic compound and an organic solvent, and then melting the film.

EP 2 178 347 A1

**Description**

Technical Field

The present invention relates to a method of producing an organic light emitting device.

Background Art

An organic light emitting device is a device containing an organic compound emitting light by injection of electric current from a pair of electrodes (organic light emitting material). Energy generated in recombination of electrons fed from a cathode and holes fed from an anode in an organic light emitting material is taken out outside as light.

As examples of the organic light emitting device, organic light emitting devices having an organic layer containing a macromolecular compound are known [for example, non-patent documents 1 to 2], and this device is advantageous for enlargement of area and lowering of cost since the organic layer can be formed simply by wet coating.

As the organic light emitting device using a macromolecular compound, an organic light emitting device is known having a layer composed of PEDOT:PSS (poly(3,4-ethylenedioxythiophene)·polystyrenesulfonic acid) in proximity with an anode [for example, non-patent document 3] .

This organic light emitting device is produced by a production method including a step of forming a layer using an acidic aqueous solution containing PEDOT:PSS on an anode, and excellent in light emission luminance, light emission efficiency and the like as compared with devices not having this layer.

(non-patent document 1) Appl. Phys. Lett., 58 (1991) pp. 1982
(non-patent document 2) Jpn. J. Appl. Phys., 30 (1991) pp. L1941
(non-patent document 3) Appl. Phys. Lett., 84 (2004) pp. 921

Disclosure of the Invention

In the organic light emitting device produced by the above-described known method, however, handling of PEDOT:PSS used in production is not necessarily easy and device performance and the like are not necessarily sufficient, in some cases.

An object of the present invention is to provide a method of producing an organic light emitting device with which an organic light emitting device excellent in light emission luminance and light emission efficiency can be obtained simply.

The present invention provides a method for producing an organic light emitting device having an anode, a layer containing an electron accepting organic compound, a hole transporting layer containing an organic compound, a light emitting layer containing a macromolecular compound, and a cathode in this order,the layer containing the electron accepting organic compound being in contact with the anode and the hole transporting layer,
wherein the layer containing the electron accepting organic compound is formed by producing a film by using a composition comprising the electron accepting organic compound and an organic solvent, and then melting the film.

Brief Explanation of Drawing

Fig. 1 is a schematic view of the structure of an organic light emitting device of the present invention.

Embodiments for Carrying Out the Invention

The anode of an organic light emitting device to be produced by the production method of the present invention feeds holes to a layer containing an electron accepting organic compound, a hole transportable layer, a light emitting layer and the like, and preferably has a work function of 4.5 eV or more. The material of the anode includes metals, alloys, metal oxides, electric conductive compounds or mixtures thereof and the like. As the material of the anode, specifically mentioned are electric conductive metal oxides such as tin oxide, zinc oxide, indium oxide, indium tin oxide (ITO) and the like, metals such as gold, silver, chromium, nickel and the like, further, mixtures or laminates of electric conductive metal oxides and metals, and the like.

From the standpoint of prevention of short circuit, the centerline average roughness (Ra) of the surface of the anode on the side in contact with the layer containing an electron accepting organic compound satisfies preferably

$$Ra < 5 \text{ nm},$$

more preferably

$$Ra < 2 \text{ nm}.$$

Ra can be measured according to JIS-B0651 to JIS-B0656 and JIS-B0671-1 and the like based on JIS-B0601-2001 of Japanese Industrial Standards JIS.

The electron accepting organic compound used in the layer containing the electron accepting organic compound of an organic light emitting device to be produced by the production method of the present invention is preferably a compound of which oxidation-reduction half-wave potential $E^1{}_{1/2}$ measured under the following conditions satisfies

$$E^1{}_{1/2} \geq +0.20 \text{ [V]}$$

from the standpoint of hole injectability from the anode.

conditions: a saturated calomel electrode (SCE), an acetonitrile solution containing tetrabutylammonium tetrafluoroborate ($TBA{\cdot}BF_4$) as a 0.1 mol/L supporting salt, temperature 20 to 22°C, a potential sweep rate: 10 to 20 mV/s

The electron accepting organic compound includes p-benzoquinone derivatives, tetracyanoquinodimethane derivatives, 1,4-naphthoquinone derivatives, diphenoquinone derivatives, fluorene derivatives and the like, and the electron accepting organic compound is preferably at least one member selected from the group consisting of p-benzoquinone derivatives and tetracyanoquinodimethane derivatives.

The p-benzoquinone derivative includes 2,3-dibromo-5,6-dicyano-p-benzoquinone (DDQ) [$E^1{}_{1/2}$ = +0.56 (V)], 2,3-dibromo-5,6-dicyano-p-benzoquinone (DBDQ) [$E^1{}_{1/2}$ = +0.53 (V)], 2,3-diiodo-5,6-dicyano-p-benzoquinone (DIDQ) [$E^1{}_{1/2}$ = +0.51 (V)], 2,3-dicyano-p-benzoquinone ($Q(CN)_2$) [$E^1{}_{1/2}$ = +0.34 (V)] and the like.

The tetracyanoquinodimethane derivative includes 5,6-tetrafluoro-7,7,8,8-tetracyanoquinodimethane (F4-TCNQ) [$E^1{}_{1/2}$ = +0.60 (V)], trifluoromethyltetracyanoquinodimethane (CF3-TCNQ) [$E^1{}_{1/2}$ = +0.43 (V)], 2,5-difluoro-tetracyanoquinodimethane (F2-TCNQ) [$E^1{}_{1/2}$ = +0.40 (V)], monofluoro-tetracyanoquinodimethane (F-TCNQ) [$E^1{}_{1/2}$ = +0.32 (V)], 11,11,12,12-tetracyanonaphtho-2,6-quinodimethane (TNAP) [$E^1{}_{1/2}$ = +0.26 (V)], tetracyanoquinodimethane (TCNQ) [$E^1{}_{1/2}$ = +0.22 (V)], decyltetracyanoquinodimethane (C10-TCNQ) [$E^1{}_{1/2}$ = +0.20 (V)], and the like.

The 1,4-naphthoquinone derivative includes 2,3-dicyano-5-nitro-1,4-naphthoquinone (DCNNQ) [$E^1{}_{1/2}$ = +0.38 (V)], 2,3-dicyano-1,4-naphthoquinone (DCNQ) [$E^1{}_{1/2}$ = +0.21 (V)], and the like.

The diphenoquinone derivative includes 3,3',5,5'-tetrabromo-diphenoquinone (TBDQ) and the like.

Examples of the fluorene derivative include 9-dicyanomethylene-2,4,5,7-tetranitro-fluorene (DTENF) [$E^1{}_{1/2}$ = +0.23 (V)] and the like.

Among them, tetracyanoquinodimethane (TCNQ) [$E^1{}_{1/2}$ = +0.22 (V), LUMO = 4.5 eV] and 2,3,5,6-tetrafluoro-7,7,8,8-tetracyanoquinodimethane (F4-TCNQ) [$E^1{}_{1/2}$ = +0.6(V), LUMO = 5.24 eV] are preferable.

The electron accepting organic compound is preferably a compound satisfying

$$-0.4 \text{ [eV]} \leq Eal-Eaw$$

, the work function energy of the anode being represented by Eaw and the lowest unoccupied molecular orbital (LUMO) energy of the electron accepting organic compound being represented by Eal.

The combination of the anode and the electron accepting organic compound satisfying this condition includes, for example, a combination of ITO [Ehh = 4.9 eV] and F4-TCNQ [Eal = 5.24 eV].

The electron accepting organic compound is preferably a compound satisfying

$$-0.2 \text{ [eV]} \leq Eal-Ehh$$

, the highest occupied molecular orbital (HOMO) energy of the organic compound contained in the hole transporting

layer being represented by Ehh and the lowest unoccupied molecular orbital (LUMO) energy of the electron accepting organic compound being represented by Eal.

The layer containing an electron accepting organic compound of an organic light emitting device to be produced by the production method of the present invention may contain two or more electron accepting organic compounds, and may contain an organic compound other than the electron accepting organic compound. Examples of the organic compound other than the electron accepting organic compound include carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidyne compounds, porphyrin compounds, polysilane compounds, poly(N-vinylcarbazole) derivatives, organic silane derivatives, and macromolecules containing these structures, aniline copolymers; electric conductive macromolecule oligomers such as thiophene oligomer, polythiophene and the like; organic electric conductive materials such as polypyrrole and the like; polyvinyl chloride, polycarbonate, polystyrene, polymethyl methacrylate, polybutyl methacrylate, polyester, polysulfone, polyphenylene oxide, polybutadiene, poly(N-vinylcarbazole), hydrocarbon resins, ketone resins, phenoxy resins, polyamide, ethylcellulose, vinyl acetate, ABS resins, polyurethane, melamine resins, unsaturated polyester resins, alkyd resins, epoxy resins, silicon resins, low molecular compounds having a crosslink group having no aromatic ring typified by an acrylate group (for example, dipentaerythritol hexaacrylate, etc.), and the like.

The hole transporting layer containing an organic compound of an organic light emitting device to be produced in the production method of the present invention may advantageously be a layer having either a function of injecting holes or a function of transporting holes from a layer on the anode side to a layer on the light emitting layer side.

The organic compound used in the hole transporting layer is usually a hole transportable material. As the hole transportable material, known materials can be appropriately selected and used, and examples thereof include carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidyne compounds, porphyrin compounds, polysilane compounds, poly(N-vinylcarbazole) derivatives, organic silane derivatives, and polymers containing these structures, aniline copolymers; electric conductive macromolecule oligomers such as thiophene oligomer, polythiophene and the like; organic electric conductive materials such as polypyrrole and the like. The above-described material may be a single component or a composition composed of a plurality of components. The above-described hole transporting layer may have a single layer structure composed of one or more of the above-described materials, or a multi-layer structure composed of several layers of the same composition or different compositions.

Examples of the hole transportable material include compounds disclosed in JP-A No. 63-70257, JP-A No. 63-175860, JP-A No. 2-135359, JP-A No. 2-135361, JP-A No. 2-209988, JP-A No. 3-37992, JP-A No. 3-152184, JP-A No. 5-263073, JP-A No. 6-1972, WO 2005/52027, JP-A No. 2006-295203, and the like.

As the hole transportable material, preferable are polymers containing a repeating unit containing the structure of an aromatic tertiary amine compound.

As the repeating unit containing the structure of an aromatic tertiary amine compound, mentioned are repeating units of the following general formula (1).

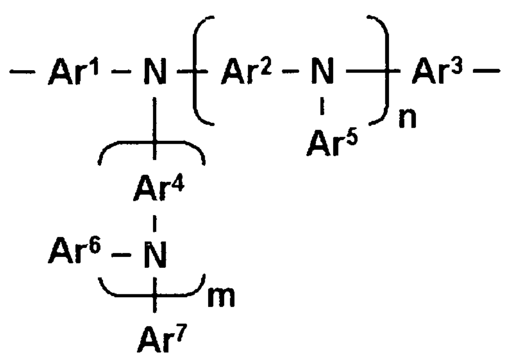

(1)

In the formula, $Ar^1$, $Ar^2$, $Ar^3$ and $Ar^4$ represent each independently an optionally substituted arylene group or an optionally substituted divalent heterocyclic group, $Ar^5$, $Ar^6$ and $Ar^7$ represent each independently an optionally substituted aryl group or an optionally substituted monovalent heterocyclic group, n and m represent each independently 0

or 1, and $0 \leq n+m \leq 2$. Further, $Ar^1$ and $Ar^3$ may be connected directly or via a divalent group such as O, S and the like.

Mentioned as the substituent are a halogen atom, alkyl group, alkyloxy group, alkylthio group, aryl group, aryloxy group, arylthio group, arylalkyl group, arylalkyloxy group, arylalkylthio group, alkenyl group, alkynyl group, arylalkenyl group, arylalkynyl group, acyl group, acyloxy group, amide group, acid imide group, imine residue, substituted amino group, substituted silyl group, substituted silyloxy group, substituted silylthio group, substituted silylamino group, cyano group, nitro group, monovalent heterocyclic group, hetero aryloxy group, hetero arylthio group, alkyloxycarbonyl group, aryloxycarbonyl group, arylalkyloxycarbonyl group, hetero aryloxycarbonyl group, carboxyl group and the like. The substituent may also be a crosslink group such as a vinyl group, acetylene group, butenyl group, acryl group, acrylate group, acrylamide group, methacryl group, methacrylate group, methacrylamide group, vinyl ether group, vinylamino group, silanol group, group having a small ring (for example, cyclopropyl group, cyclobutyl group, epoxy group, oxetane group, diketene group, episulfide group or the like), lactone group, lactam group, or group containing the structure of a siloxane derivative, or the like.

Here, the crosslink group means a substituent having a function of mutually connecting polymer chains.

In addition to the above-mentioned groups, combinations of groups capable of forming an ester bond or amide bond (for example, a combination of ester group and amino group, a combination of ester group and hydroxyl group, etc.) and the like can also be utilized as the crosslink group.

As the arylene group, a phenylene group and the like are mentioned, and as the divalent heterocyclic group, a pyridinediyl group and the like are mentioned, and these groups may have a substituent.

As the aryl group, a phenyl group, naphthyl group and the like are mentioned, and as the monovalent heterocyclic group, a pyridyl group and the like are mentioned, and these groups may have a substituent. Examples of the repeating unit of the above-described formula (1) include the following repeating units, and repeating units obtained by bonding a substituent to these units, and the like.

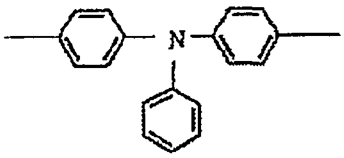

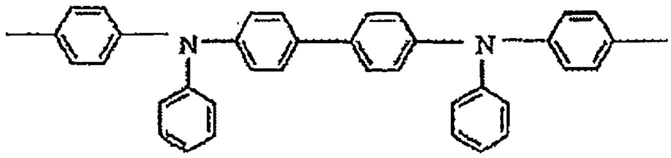

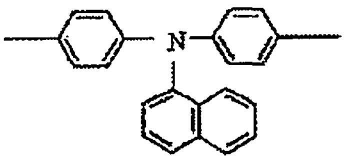

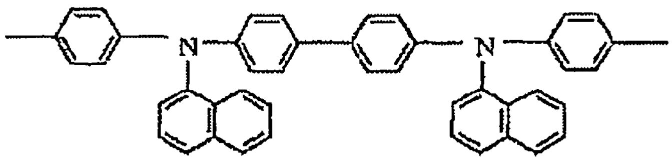

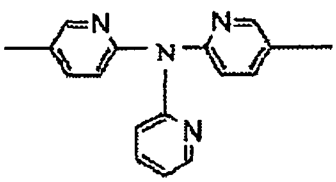

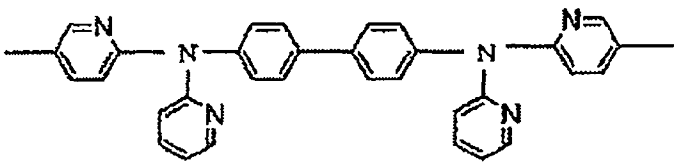

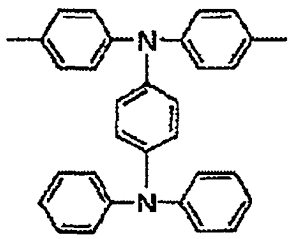

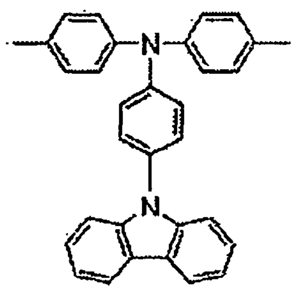

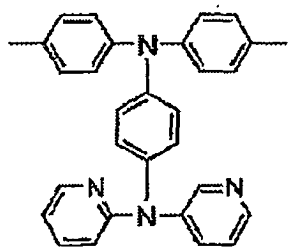

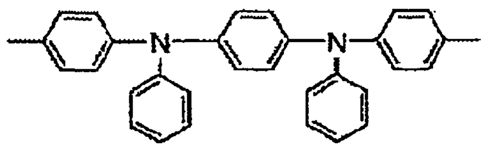

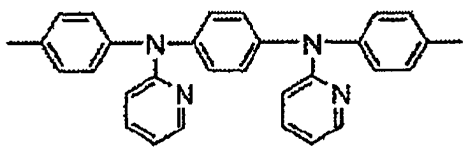

The polymer containing a repeating unit containing the structure of an aromatic tertiary amine compound may further have other repeating units. The other repeating units include arylene groups such as a phenylene group, fluorenediyl group and the like.

Of these polymers, those containing a crosslink group are preferable.

In the case of formation by a coating method of both a hole transporting layer and a light emitting layer when these groups are in contact with each other, a layer coated previously (lower layer) is dissolved in a solvent contained in a layer to be coated later (upper layer) to give a difficulty in fabricating a laminated structure in some cases. In these cases, methods of insolubilizing the lower layer in a solvent can be used.

The insolubilization methods include a method in which a macromolecular compound having a crosslink group is used as the material of the lower layer, a method in which a low molecular compound having a crosslink group having an aromatic ring typified by an aromatic bisazide is mixed as a crosslinking agent, a method in which a low molecular compound having a crosslink group having no aromatic ring typified by an acrylate group is mixed as a crosslinking agent, and a method in which the lower layer is heated to be insolubilized against a solvent used in fabrication of the upper layer. The temperature of heating in the case of heating of the lower layer is usually about 150°C to 300°C, and the time of heating is usually about 1 minute to 1 hour.

Other methods for laminating the lower layer without dissolution include methods of using solutions of different polarities for adjacent layers, and include, for example, a method in which a water-soluble polymer compound is used in the lower layer and an oil-soluble polymer compound is used in the upper layer, thereby preventing dissolution of the lower layer even after coating thereof, and other methods.

When the hole transportable material is a low molecular compound (low molecular hole transportable material) such as a pyrazoline derivative, arylamine derivative, stilbene derivative, triphenyldiamine derivative or the like, a hole transporting layer can be formed using a vacuum vapor deposition method. A hole transporting layer may also be formed by a coating method using a mixed solution obtained by dispersing the low molecular hole transportable material in a polymer compound not extremely disturbing charge transportation and showing no strong absorption against visible light such as poly(N-vinylcarbazole), polyaniline or derivatives thereof, polythiophene or derivatives thereof, poly(p-phenylenevinylene) or derivatives thereof, poly(2,5-thienylenevinylene) or derivatives thereof, polycarbonate, polyacrylate, polymethyl acrylate, polymethyl methacrylate, polystyrene, polyvinyl chloride, polysiloxane, and the like.

Preferable are hole transportable materials satisfying

$$-0.2\ [\mathrm{eV}] \leq Eal-Ehh$$

, the highest occupied molecular orbital (HOMO) energy of the hole transportable material contained in the hole transporting layer of the organic light emitting device of the present invention being represented by Ehh and the lowest unoccupied molecular orbital (LUMO) energy of the electron accepting organic compound being represented by Eal.

As the combination of the hole transportable material and the electron accepting organic compound satisfying this condition, for example, a combination of TFB [Ehh = 5.4 eV] and F4-TCNQ [Eal = 5.24 eV] disclosed in JP-A No.

2006-295203, and the like are mentioned.

The light emitting layer of the organic light emitting device of the present invention has a function capable of injecting holes from a layer adjacent to the anode side and injecting electrons from a layer adjacent to the cathode side in application of electric field, a function of moving injected charges (electrons and holes) by the force of the electric field, and a function of providing a spot of recombination of electrons and holes, leading to light emission.

As the macromolecular compound contained in the light emitting layer of the organic light emitting device of the present invention, macromolecular light emitting materials capable of emitting fluorescence or phosphorescence are mentioned.

As the macromolecular light emitting material, conjugated polymer compounds such as polyfluorene derivatives (PF), polyparaphenylenevinylene derivatives (PPV), polyphenylene derivatives (PP), polyparaphenylene derivatives (PPP), polythiophene derivatives, polydialkylfluorene (PDAF), polyfluorenebenzothiadiazole (PFBT), polyalkylthiophene (PAT) and the like which are known polymer light emitting materials can be suitably used.

The light emitting layer may further contain organic dye compounds such as perylene dyes, coumarin dyes, rhodamine dyes, rubrene, perylene, 9,10-diphenylanthracene, tetraphenylbutadiene, Nile Red, coumarin 6, quinacridone, naphthalene derivatives, anthracene or derivatives thereof, perylene or derivatives thereof, dyes such as polymethine dyes, xanthene dyes, cyanine dyes and the like, metal complexes of 8-hydroxyquinoline or derivatives thereof, aromatic amines, tetraphenylcyclopentadiene or derivatives thereof, or tetraphenylbutadiene or derivatives thereof, and the like.

Examples of the macromolecular light emitting material include polyfluorene, derivatives and copolymers thereof, polyarylene, derivatives and copolymers thereof, polyarylenevinylene, derivatives and copolymers thereof, and (co) polymers of aromatic amines and derivatives thereof, disclosed in WO 99/13692, WO 99/48160, GB 2340304A, WO 00/53656, WO 01/19834, WO 00/55927, GB 2348316, WO 00/46321, WO 00/06665, WO 99/54943, WO 99/54385, US 5777070, WO 98/06773, WO 97/05184, WO 00/35987, WO 00/53655, WO 01/34722, WO 99/24526, WO 00/22027, WO 00/22026, WO 98/27136, US 573636, WO 98/21262, US 5741921, WO 97/09394, WO 96/29356, WO 96/10617, EP 0707020, WO 95/07955, JP-A No. 2001-181618, JP-A No. 2001-123156, JP-A No. 2001-3045, JP-A No. 2000-351967, JP-A No. 2000-303066, JP-A No. 2000-299189, JP-A No. 2000-252065, JP-A No. 2000-136379, JP-A No. 2000-104057, JP-A No. 2000-80167, JP-A No. 10-324870, JP-A No. 10-114891, JP-A No. 9-111233, JP-A No. 9-45478 and the like.

As the polymer compound contained in the light emitting layer of the organic light emitting device of the present invention, there can be used non-conjugated macromolecular compounds [polymers containing, for example, polyvinylcarbazole, polyvinyl chloride, polycarbonate, polystyrene, polymethyl methacrylate, polybutyl methacrylate, polyester, polysulfone, polyphenylene oxide, polybutadiene, poly(N-vinylcarbazole), hydrocarbon resin, ketone resin, phenoxy resin, polyamide, ethylcellulose, vinyl acetate, ABS resin, polyurethane, melamine resin, unsaturated polyester resin, alkyd resin, epoxy resin, silicon resin, carbazole derivative, triazole derivative, oxazole derivative, oxadiazole derivative, imidazole derivative, polyarylalkane derivative, pyrazoline derivative, pyrazolone derivative, phenylenediamine derivative, arylamine derivative, amino-substituted chalcone derivative, styrylanthracene derivative, fluorenone derivative, hydrazone derivative, stilbene derivative, silazane derivative, aromatic tertiary amine compound, styrylamine compound, aromatic dimethylidyne compound, porphyrin compound, polysilane compound, poly(N-vinylcarbazole) derivative, organic silane derivative].

The light emitting layer may also be constituted of, for example, a composition composed of a non-conjugated macromolecular compound and the above-described organic dye compound.

As the low molecular organic dye compound, exemplified are compounds described in JP-A Nos. 57-51781 and 59-194393, and the like.

The electron injection layer and electron transporting layer which can be present in the organic light emitting device of the present invention may advantageously be a layer having any of a function of injecting electrons from a cathode, a function of transporting electrons or a function of blocking holes injected from an anode. As the material of the electron injection layer and electron transporting layer, known materials can be appropriately selected and used, and examples thereof include triazole derivatives, oxazole derivatives, oxadiazole derivatives, imidazole derivatives, fluorenone derivatives, anthraquinodimethane derivatives, anthrone derivatives, diphenylquinone derivatives, thiopyran dioxide derivatives, carbodiimide derivatives, fluorenylidenedimethane derivatives, distyrylpyrazine derivatives; aromatic ring tetracarboxylic anhydrides such as naphthalene, perylene and the like; phthalocyanine derivatives, various metal complexes typified by metal complexes of 8-quinolinol derivatives and metal complexes having metal phthalocyanine, benzooxazole or benzothiazole as a ligand, organic silane derivatives, and the like. The above-described electron injection layer and the above-described electron transporting layer may have a single layer structure composed of one or more of the above-described materials or a multi-layer structure composed of several layers of the same composition or different compositions.

The preferable thickness of each organic layer in the organic light emitting device of the present invention varies depending on the kind of the material and the layer structure and is not particularly restricted, and preferably in the range of several nm to 1 μm since, in general, when the thickness is too small, defects such as pin holes and the

like tend to be generated and adversely when the thickness is too large, high application voltage is required and the efficiency tends to deteriorate.

The cathode present in the organic light emitting device of the present invention feeds electrons to the electron injection layer, electron transporting layer, light emitting layer and the like, and as the material of the cathode, metals, alloys, metal halides, metal oxides, electric conductive compounds or mixtures thereof can be used. Examples of the material of the cathode include alkali metals (Li, Na, K, and the like) and fluorides or oxides thereof, alkaline earth metals (Mg, Ca, Ba, Cs, and the like) and fluorides or oxides thereof, gold, silver, lead, aluminum, alloy or mixed metals (sodium-potassium alloy, sodium-potassium mixed metal, lithium-aluminum alloy, lithium-aluminum mixed metal, magnesium-silver alloy or magnesium-silver mixed metal, and the like), rare earth metals (indium, ytterbium, and the like), further, laminates thereof, and the like.

The structure of the organic light emitting device produced by the production method of the present invention includes

anode/layer containing an electron accepting organic compound/hole transporting layer/light emitting layer/cathode,

anode/layer containing an electron accepting organic compound/hole transporting layer/light emitting layer/electron injection layer/cathode,

anode/layer containing an electron accepting organic compound/hole transporting layer/light emitting layer/electron transporting layer/electron injection layer/cathode,

and the like,

and desirable are structures in which an anode composed of indium tin oxide (ITO) is formed on a glass or plastic substrate, a layer containing an electron accepting organic compound is formed on the surface of the anode, a hole transporting layer is formed on this, a light emitting layer is formed on this, and a cathode is formed on this.

The production method of the present invention is a method of producing the above-described organic light emitting device, namely, an organic light emitting device having an anode, a layer containing an electron accepting organic compound, a hole transporting layer containing an organic compound, a light emitting layer containing a macromolecular compound, and a cathode in this order, the layer containing an electron accepting organic compound being in contact with the anode and the hole transporting layer,

wherein the layer containing the electron accepting organic compound is formed by producing a film by using a composition containing the electron accepting organic compound and an organic solvent, and melting this film.

Examples, preferable examples and the like of the electron accepting organic compound contained in the composition containing the electron accepting organic compound and an organic solvent used in the production method of the present invention are as describes above.

As the organic solvent, those uniformly dissolving or dispersing constituent components of the layers and which are stable can be appropriately selected from known solvents and used. As such solvents, mentioned are alcohols (methanol, ethanol, isopropyl alcohol, and the like), nitrile solvents (acetonitrile, benzonitrile, and the like), ketones (acetone, methyl ethyl ketone, and the like), organic chlorines (chloroform, 1,2-dichloroethane, and the like), aromatic hydrocarbons (benzene, toluene, xylene and the like), aliphatic hydrocarbons (n-hexane, cyclohexane, and the like), amides (dimethylformamide, and the like), and sulfoxides (dimethyl sulfoxide, and the like). The solvent may be a single component or a mixture of several components.

In the case of use, for example, of TCNQ or F4-TCNQ as the electron accepting organic compound, acetonitrile is preferable as the organic solvent. The concentration of the electron accepting organic compound in the solvent is not particularly restricted, and usually 0.5 wt% or more and 10 wt% or less.

This composition may contain a resin, and the resin can be in the form of dissolution or dispersion in the organic solvent. Examples of the above-described resin include non-conjugated macromolecules (for example, polyvinylcarbazole), and conjugated macromolecules (for example, polyolefin polymer). More specifically, the resin can be selected from, for example, polyvinyl chloride, polycarbonate, polystyrene, polymethyl methacrylate, polybutyl methacrylate, polyester, polysulfone, polyphenylene oxide, polybutadiene, poly(N-vinylcarbazole), hydrocarbon resin, ketone resin, phenoxy resin, polyamide, ethylcellulose, vinyl acetate, ABS resin, polyurethane, melamine resin, unsaturated polyester resin, alkyd resin, epoxy resin, silicon resin and the like, according to the object.

This composition may contain an antioxidant, viscosity regulator, and the like, according to the object.

In the production method of the present invention, preferable as the method for fabricating a film using the composition are coating methods (casting method, spin coat method, bar coat method, blade coat method, roll coat method, gravure printing, screen printing, inkjet method and the like).

In the above-described coating methods, a film can be formed by coating the composition on a desired layer (or an anode).

In an inkjet method, known components can be used for dischargeability of an ink and reproducibility thereof. For example, a solvent of high boiling point (anisole, bicyclohexylbenzene and the like) can be used as the component for suppressing evaporation from a nozzle. It is preferable to select the component so as to give a viscosity of the solution of 1 to 100 mPa·s.

The atmosphere in coating is not particularly restricted, and the coating may be carried out in air or under an inert atmosphere. After coating, drying is usually performed. The drying temperature is not particularly restricted, and in the range of about 15 to 30°C. The atmosphere in drying is not particularly restricted, and the drying may be performed under the atmosphere for coating. The drying time is usually about 1 minute to 10 minutes.

In the production method of the present invention, a film is formed using the above-described composition and the film is melted.

Melting is performed usually by heating, and the heating temperature varies depending on the composition, and is not particularly restricted provided that the formed film is melted at the temperature, and it is usually about 100°C to 300°C, and in the case of use, for example, of a composition composed of acetonitrile and F4-TCNQ, the preferable temperature is 150°C to 250°C.

The melting time is not particularly restricted provided that the fabricated film is melted during this time, and it is usually 3 minutes to 30 minutes, and in the case of use, for example, of a mixed composition composed of acetonitrile and F4-TCNQ, the preferable time is 5 minutes to 15 minutes.

The atmosphere for melting is not particularly restricted, and the melting may be performed in air or under an inert atmosphere.

After melting of the film, the film is cooled at a temperature lower than the heating temperature, usually at room temperature, thereby returning the film made into a liquid phase by melting into a solid phase.

Melting of the film can be confirmed visually, or, confirmed by comparing the thicknesses before and after melting by a stylus profilometer. For example, in the case of a film formed at a revolution of 2000 rpm according to a spin coat method using a composition prepared by mixing F4-TCNQ in an amount of 1 wt% into acetonitrile, the thickness after melting becomes 1/5 or less of the thickness before melting.

In the production method of the present invention, an anode, a layer containing an electron accepting organic compound, a hole transporting layer containing an organic compound, a light emitting layer containing a polymer compound, and a cathode may be formed in this order, or a cathode, a light emitting layer containing a polymer compound, a hole transporting layer containing an organic compound, a layer containing an electron accepting organic compound, and an anode may be formed in this order, and it is preferable from the standpoint of simplicity of the production process that an anode, a layer containing an electron accepting organic compound, a hole transporting layer containing an organic compound, a light emitting layer containing a polymer compound, and a cathode are formed in this order.

In the production method of the present invention, the method for forming each layer other than the above-described layer containing an electron accepting organic compound is not particularly restricted and known methods can be used, and it is preferable, from the standpoint of simplicity of the production process, to form the layer by a coating method (casting method, spin coat method, bar coat method, blade coat method, roll coat method, gravure printing, screen printing, inkjet method, and the like). In the above-described coating method, the layer can be formed by preparing a coating solution, and coating the coating solution on a desired layer (or electrode) and drying this. The coating solution may contain a resin, and the resin can be in the form of dissolution or dispersion in a solvent. As the above-described resin, non-conjugated polymers (for example, polyvinylcarbazole) and conjugated polymers (for example, polyolefin polymer) can be used. It can be selected according to the object from, for example, polyvinyl chloride, polycarbonate, polystyrene, polymethyl methacrylate, polybutyl methacrylate, polyester, polysulfone, polyphenylene oxide, polybutadiene, poly( N-vinylcarbazole), hydrocarbon resin, ketone resin, phenoxy resin, polyamide, ethylcellulose, vinyl acetate, ABS resin, polyurethane, melamine resin, unsaturated polyester resin, alkyd resin, epoxy resin, silicon resin and the like. The coating solution may contain an antioxidant, viscosity regulator, and the like according to the object.

As the solvent for the coating solution, for example, those uniformly dissolving or dispersing components of a thin film and which are stable can be appropriately selected from known solvents and used providing that the solvent does not invade the above-described layer containing an electron accepting organic compound Such solvents include alcohols (methanol, ethanol, isopropyl alcohol, and the like), ketones (acetone, methyl ethyl ketone, and the like), organic chlorines (chloroform, 1,2-dichloroethane, and the like), aromatic hydrocarbons (benzene, toluene, xylene, and the like), aliphatic hydrocarbons (n-hexane, cyclohexane, and the like), amides (dimethylformamide, and the like), sulfoxides (dimethyl sulfoxide, and the like), and the like. The solvent may be a single component or a mixture of several components.

In an inkjet method, known components can be used for dischargeability of an ink and reproducibility thereof. For example, a solvent of high boiling point (anisole, bicyclohexylbenzene and the like) can be used as the component for suppressing evaporation from a nozzle. It is preferable to select the component so as to give a viscosity of the solution of 1 to 100 mPa·s.

In the production method of the present invention, it is preferable from the standpoint of no invasion of the layer containing an electron accepting organic compound that no solvent capable of dissolving the electron accepting organic compound is used in a step other than the step of forming the above-described layer containing the electron accepting organic compound.

Particularly, it is preferable that no solvent capable of dissolving the electron accepting organic compound is used in a step of forming a hole transporting layer.

The organic light emitting device produced by the production method of the present invention can be produced without substantial use of water as a solvent, and is excellent in light emission luminance and light emission efficiency as compared with devices having no layer containing an electron accepting organic compound. This organic light emitting device is excellent also in a life property.

Though the application of the organic light emitting device produced by the production method of the present invention is not particularly restricted, this device can be used in a light source for illumination, a light source for sign, a light source for backlight, a display apparatus, a printer head, and the like. For the display apparatus, constitutions such as segment type, dot matrix type and the like can be selected using known driving technologies, driving circuits and the like.

## EXAMPLES

### Example 1

The structure and production method of an organic light emitting device in the present invention will be illustrated below referring to Fig. 1.

An electron accepting organic compound, F4-TCNQ, was dissolved in a weight concentration of 1% in an acetonitrile solvent to prepare an electron accepting organic compound solution 1. The electron accepting organic compound solution 1 was coated by a spin coat method at a revolution of 2000 rpm on a glass substrate on which an ITO anode had been formed, thereby forming an electron accepting organic compound film. The glass substrate after film formation was heated in air at 180°C for 10 minutes to melt the electron accepting organic compound film.

The centerline average roughness (Ra) of the surface of the ITO anode measured by a method described in JIS-B0671-1 was 1 nm.

Then, a hole transportable macromolecular material exemplified as P1 in WO 2005/52027 was prepared, and dissolved in a weight concentration of 0.5% in a xylene solvent to obtain a hole transportable macromolecular material solution 1. The hole transportable macromolecular material solution 1 was spin-coated so as to give a film thickness of 20 nm on the above-described glass substrate on which the electron accepting organic compound film had been formed, thereby obtaining a hole transporting layer. The glass substrate after film formation was heated at 200°C for 15 minutes to insolubilize the hole transporting layer.

Then, a macromolecular light emitting material 1 was prepared and dissolved in a weight concentration of 1.4% in a xylene solvent, to obtain a macromolecular light emitting material solution 1. The macromolecular light emitting material solution 1 was spin-coated so as to give a film thickness of 70 nm on the above-described glass substrate on which the hole transporting layer had been formed, thereby obtaining a light emitting layer. Here, as the macromolecular light emitting material 1, BP361 manufactured by SUMATION K.K. was used.

Then, the above-described glass substrate on which the light emitting layer had been formed was heated at 130°C for 45 minutes to evaporate the solvent.

Then, on the above-described glass substrate on which the light emitting layer had been formed, barium was deposited with a thickness of 5 nm by a vacuum vapor deposition apparatus, then, aluminum was deposited with a thickness of 100 nm, to obtain a cathode.

Then, the above-described cathode-formed glass substrate was encapsulated using a two part epoxy resin and an encapsulating glass plate, to give an organic light emitting device 1.

### Example 2

An electron accepting organic compound, TCNQ, was dissolved in a weight concentration of 1% in an acetonitrile solvent to prepare an electron accepting organic compound solution 1. The electron accepting organic compound solution 1 was coated by a spin coat method at a revolution of 2000 rpm on a glass substrate on which an ITO anode had been formed, thereby forming an electron accepting organic compound film. The glass substrate after film formation was heated in air at 180°C for 10 minutes to melt the electron accepting organic compound film.

Then, a hole transporting layer and light emitting layer were formed sequentially in the same manner as in Example 1, and a cathode was formed in the same manner as in Example 1, then, insulation was performed to obtain an organic light emitting device 2.

### Example 3

An electron accepting organic compound, DDQ, was dissolved in a weight concentration of 1% in an acetonitrile solvent to prepare an electron accepting organic compound solution 1. The electron accepting organic compound solution 1 was coated by a spin coat method at a revolution of 2000 rpm on a glass substrate on which an ITO anode had been formed, thereby forming an electron accepting organic compound film. The glass substrate after film formation was

heated in air at 180°C for 10 minutes to melt the electron accepting organic compound film.

Then, a hole transporting layer and light emitting layer were formed sequentially in the same manner as in Example 1, and a cathode was formed in the same manner as in Example 1, then, insulation was performed to obtain an organic light emitting device 3.

Comparative Example 1

An organic light emitting device was produced in the same production method as in Example 1 excepting that an electron accepting organic compound film was not formed, obtaining an organic light emitting device 4.

A constant voltage·current power source was prepared, and the ITO anode of the produced organic light emitting devices 1 to 4 was connected to an anode of the power source and the aluminum cathode thereof was connected to a cathode of the power source, and voltage was applied and electric current was injected to cause light emission of the organic light emitting device. The light emission luminance of each device and the maximum light emission efficiency of each device when the driving voltage was 6 V are shown in Table 1.

Table 1

| Organic light emitting device No. | Light emission luminance [Cd/m$^2$] | Light emission efficiency [Cd/A] |
|---|---|---|
| Light emitting device 1 (Example 1) | 1840 | 6.7 |
| Light emitting device 2 (Example 2) | 1760 | 6.6 |
| Light emitting device 3 (Example 3) | 360 | 4.3 |
| Light emitting device 4 (Comparative Example 1) | 2.3 | 0.93 |

As apparent from Table 1, the light emission luminance and light emission efficiency of the organic light emitting devices 1 to 3 of the present invention having an electron accepting organic compound film were higher remarkably as compared with those in Comparative Example 1 using no electron accepting organic compound film.

Examples of the present invention have been mentioned above, but the present invention is not limited to these example.

Reference Example 1

On a glass substrate on which an ITO anode had been formed, a hole injection material aqueous solution was formed by a spin coat method, obtaining a hole injection layer having a thickness of 60 nm. The glass substrate after film formation was heated at 200°C for 10 minutes to insolubilize the hole injection layer. As the hole injection material solution, a PEDOT:PSS solution (poly(3,4-ethylenedioxythiophene)·polystyrenesulfonic acid, product name: Baytron) available from Stark V TECH K.K. was used.

Hereinafter, a hole transporting layer, light emitting layer and cathode were formed sequentially and insulation was performed in the same manner as in Example 1, to obtain an organic light emitting device 5.

The light emission luminance and light emission efficiency of the organic light emitting device 5 measured in the same manner as for the organic light emitting devices 1 to 4 were 1210 [Cd/m$^2$] and 6.8 [Cd/A], respectively.

Industrial Applicability

According to the production method of the present invention, an organic light emitting device excellent in light emission luminance and light emission efficiency can be produced without substantial use of water as a solvent.

**Claims**

1. A method for producing an organic light emitting device having an anode, a layer containing an electron accepting organic compound, a hole transporting layer containing an organic compound, a light emitting layer containing a macromolecular compound, and a cathode in this order,the layer containing the electron accepting organic compound being in contact with the anode and the hole transporting layer,
   wherein the layer containing the electron accepting organic compound is formed by producing a film by using a composition comprising the electron accepting organic compound and an organic solvent, and then melting the film.

2. The method for producing an organic light emitting device according to Claim 1, wherein the electron accepting organic compound has an oxidation-reduction half- wave potential ($E^1_{1/2}$) measured under the following conditions satisfies $E^1_{1/2} \geq +0.20$ [V]
conditions: a saturated calomel electrode (SCE), an acetonitrile solution containing tetrabutylammonium tetrafluoroborate ($TBA \cdot BF_4$) as a 0.1 mol/L supporting salt, a temperature 20 to 22°C, a potential sweep rate 10 to 20 mV/s.

3. The method for producing an organic light emitting device according to Claim 1 or 2, wherein the electron accepting organic compound is at least one member selected from the group consisting of p-benzoquinone derivatives and tetracyanoquinodimethane derivatives.

4. The method for producing an organic light emitting device according to any one of Claims 1 to 3, wherein a surface of the anode has a centerline average roughness (Ra) satisfying Ra < 5 nm,the surface being in contact with the layer containing an electron accepting organic compound.

5. The method for producing an organic light emitting device according to any one of Claims 1 to 4, wherein in a step other than the step of forming the layer containing the electron accepting organic compound, no solvent capable of dissolving the electron accepting organic compound is used.

6. An organic light emitting device produced by the production method according to any one of Claims 1 to 5.

FIG. 1

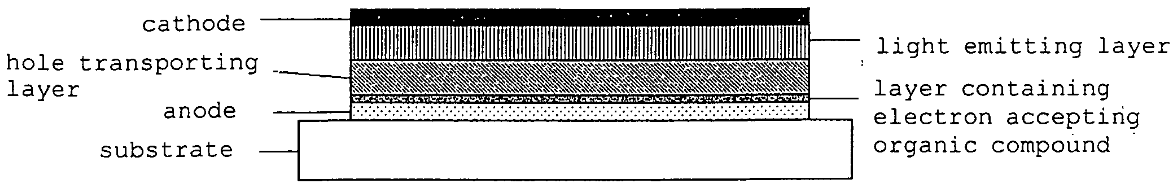
cathode
hole transporting layer
anode
substrate
light emitting layer
layer containing electron accepting organic compound

## INTERNATIONAL SEARCH REPORT

International application No.
PCT/JP2008/062776

A. CLASSIFICATION OF SUBJECT MATTER
*H05B33/10*(2006.01)i, *H01L51/50*(2006.01)i

According to International Patent Classification (IPC) or to both national classification and IPC

B. FIELDS SEARCHED

Minimum documentation searched (classification system followed by classification symbols)
H05B33/10, H01L51/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2003-157981 A (Toyota Industries Corp.), 30 May, 2003 (30.05.03), Claim 2; Par. Nos. [0010] to [0012], [0022] to [0027], [0031], [0034]; Fig. 2 (Family: none) | 1-6 |
| Y | JP 2007-162009 A (Sumitomo Chemical Co., Ltd.), 28 June, 2007 (28.06.07), Claims (Family: none) | 1-6 |
| Y | JP 2006-244917 A (Pioneer Corp.), 14 September, 2006 (14.09.06), Claims 1, 5, 9; Par. Nos. [0004], [0010], [0019], [0023], [0035] to [0039], [0054], [0059] (Family: none) | 1-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 14 October, 2008 (14.10.08) | 28 October, 2008 (28.10.08) |
| Name and mailing address of the ISA/ Japanese Patent Office | Authorized officer |
| Facsimile No. | Telephone No. |

Form PCT/ISA/210 (second sheet) (April 2007)

**INTERNATIONAL SEARCH REPORT**

International application No.
PCT/JP2008/062776

C (Continuation). DOCUMENTS CONSIDERED TO BE RELEVANT

| Category* | Citation of document, with indication, where appropriate, of the relevant passages | Relevant to claim No. |
|---|---|---|
| Y | JP 9-120890 A (Mitsubishi Chemical Corp.), 06 May, 1997 (06.05.97), Claim 1; Par. Nos. [0006] to [0011]; Par. No. [0040], table 1; Par. No. [0050] (Family: none) | 4 |
| A | JP 2007-49153 A (Osram Opto Semiconductors GmbH), 22 February, 2007 (22.02.07), Full text; all drawings & US 2007/0029556 A1 & EP 1753047 A2 | 1-6 |
| A | JP 2006-216858 A (Riken, Japan), 17 August, 2006 (17.08.06), Full text; all drawings (Family: none) | 1-6 |
| A | JP 2006-73636 A (Japan Science and Technology Agency), 16 March, 2006 (16.03.06), Full text; all drawings (Family: none) | 1-6 |
| A | JP 2007-518220 A (LG Chem, Ltd.), 05 July, 2007 (05.07.07), Full text; all drawings & US 2005/0255334 A1 & EP 1745519 A & WO 2005/109542 A1 & TW 265753 B & KR 10-2006-0047778 A & CN 1906777 A | 1-6 |
| A | JP 2002-203674 A (Fuji Nameplate Co., Ltd.), 19 July, 2002 (19.07.02), Full text; all drawings (Family: none) | 1-6 |
| A | JP 2002-56985 A (Mitsubishi Chemical Corp.), 22 February, 2002 (22.02.02), Full text; all drawings (Family: none) | 1-6 |
| A | JP 2007-42729 A (Konica Minolta Holdings, Inc.), 15 February, 2007 (15.02.07), Full text; all drawings (Family: none) | 1-6 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 63070257 A
- JP 63175860 A
- JP 2135359 A
- JP 2135361 A
- JP 2209988 A
- JP 3037992 A
- JP 3152184 A
- JP 5263073 A
- JP 6001972 A
- WO 200552027 A
- JP 2006295203 A
- WO 9913692 A
- WO 9948160 A
- GB 2340304 A
- WO 0053656 A
- WO 0119834 A
- WO 0055927 A
- GB 2348316 A
- WO 0046321 A
- WO 0006665 A
- WO 9954943 A
- WO 9954385 A
- US 5777070 A
- WO 9806773 A
- WO 9705184 A
- WO 0035987 A
- WO 0053655 A
- WO 0134722 A
- WO 9924526 A
- WO 0022027 A
- WO 0022026 A
- WO 9827136 A
- US 573636 A
- WO 9821262 A
- US 5741921 A
- WO 9709394 A
- WO 9629356 A
- WO 9610617 A
- EP 0707020 A
- WO 9507955 A
- JP 2001181618 A
- JP 2001123156 A
- JP 2001003045 A
- JP 2000351967 A
- JP 2000303066 A
- JP 2000299189 A
- JP 2000252065 A
- JP 2000136379 A
- JP 2000104057 A
- JP 2000080167 A
- JP 10324870 A
- JP 10114891 A
- JP 9111233 A
- JP 9045478 A
- JP 57051781 A
- JP 59194393 A


### Non-patent literature cited in the description


- *Appl. Phys. Lett.,* 1991, vol. 58, 1982
- *Jpn. J. Appl. Phys.,* 1991, vol. 30, L1941
- *Appl. Phys. Lett.,* 2004, vol. 84, 921